# EUROPEAN PATENT SPECIFICATION

(11) **EP 1 508 813 B1**
(45) Date of publication and mention of the grant of the patent: **31.01.2007**
(21) Application number: 03103205.5
(22) Date of filing: 20.08.2003
(51) Int. Cl.: G01R 31/319, G01R 31/3193, H04L 1/20

(54) **Spectral jitter analysis allowing jitter modulation waveform analysis**
Spektrale Jitter-Analyse mit Jitter-Modulation-Wellenform-Analyse
Analyse spectrale de jitter permettant une analyse de forme d'onde par modulation de jitter

(43) Date of publication of application: 23.02.2005
(73) Proprietor: Agilent Technologies, Inc., Santa Clara, CA 95051 (US)
(72) Inventor: Laquai, Bernd, 71034, Böblingen (DE)
(74) Representative: Schoppe, Fritz

(56) References cited:
- EP-A- 1 054 401
- EP-A- 1 213 870
- WO-A-03/093842
- US-A- 5 563 921
- US-A1- 2003 016 734
- US-B1- 6 546 345
- DENNIS PETERICH: "Fibre Channel - methodologies for jitter and signal quality specification - MJSQ" INTERNATIONAL COMMITTEE FOR INFORMATION TECHNOLOGY STANDARIZATION, 10 March 2003 (2003-03-10), pages 1-200, XP002274445
- AGILENT: "Jitter Analysis Techniques for High Data Rates" AGILENT TECHNICAL REPORTS, 3 February 2003 (2003-02-03), pages 1-27, XP002274446
- YAMAGUCHI T J ET AL: "A new method for testing jitter tolerance of SerDes devices using sinusoidal jitter" PROCEEDINGS INTERNATIONAL TEST CONFERENCE 2002. ITC 2002. BALTIMORE, MD, OCT. 7-10, 2002, INTERNATIONAL TEST CONFERENCE, NEW YORK, NY: IEEE, US, 7 October 2002 (2002-10-07), pages 717-725, XP010609801 ISBN: 0-7803-7542-4

## Description

### BACKGROUND OF THE INVENTION

The present invention relates to jitter analysis for signals.

Characterization of the transient behavior of high-speed digital circuits, i.e. the transition from a logical zero to a logical one and vice versa, has become increasingly important for designing as well as manufacturing such digital circuits. Timing instabilities such as jitter can cause single transmission errors, or temporary or even permanent outage of an entire communication system, and have to be avoided. The standard overall figure of merit for a communications system is the Bit Error Rate (BER), however a high value of BER does not necessarily indicate timing problems, as there are many other potential sources of error in a system (for example level/threshold mismatch).

One of the key specifications of high-speed circuits with respect to timing is Jitter. ITU-T G.701 defines jitter as short-term non-cumulative variations of the significant instants of a digital signal from their ideal positions in time. The significant instant can be any convenient, easily identifiable point on the signal such as the rising or falling edge of a pulse or the sampling instant. By plotting the relative displacement in the instants between an ideal pulse train and a real pulse train that has some timing jitter, the so-called jitter function is obtained. In addition to the jitter time function, the jitter spectrum can be displayed in the frequency domain. Jitter can also be displayed using so-called Jitter-Histograms showing the likelihood for a transition.

Jitter histograms can be measured using e.g. an oscilloscope, a time interval analyzer, or a BER Tester. The applicant Agilent Technologies provides various BER test equipment such as the Agilent® 81250 ParBERT®. Histogram values are obtained from a BER vs. Sample Delay measurement (generally referred to as the so-called bathtub curve) by taking the absolute value of the derivative.

Various ways for jitter analysis are disclosed in the EP-A-1265391 by the same applicant, the teaching thereof shall be incorporated herein by reference. International Patent Application PCT/EP02/0484, by the same inventor and applicant, discloses spectral jitter analysis - the teaching thereof shall be incorporated herein by reference.
The document The document "Fibre Channel - Methodologies for Jitter and Signal Quality Specification - MJSQ", Rev 10.0, March 10, 2003 discloses definitions and test methodologies to enable a jitter determination of high speed serial signals. Further, this document discloses of measuring deterministic jitter and random jitter and separating those jitter components by means of a tail fit method.

EP1213870 of the same applicant discloses a jitter generation with a controllable variable delay unit, in order to induce a defined jitter function as well a defined jitter spectrum to a test signal to be provided to a device under test.

US 5,563,921 discloses a jitter detection apparatus for detecting phase variations in a target signal having a certain frequency. The apparatus comprises a phase locked loop with a phase/frequency comparator that outputs an error signal indicative of a phase difference between the target frequency and a loop frequency, a loop filter for low pass filtering the error signal and a jitter detection filter for detecting phase variations in the target signal.

WO 03/093842 of the same applicant discloses providing a jitter analysis for a digital signal. Therefore, an error signal of a plurality of error values is determined, the error values being derived from a comparison of a result of a detection for successive transitions occurring in the digital signal with an expected signal. A spectral jitter analysis is provided for the error signal in order to detect spectral components in the error signal.

### SUMMARY OF THE INVENTION

It is an object of the invention to provide an improved jitter analysis. The object is solved by the independent claims. Preferred embodiments are shown by the dependent claims.

For providing a jitter analysis for a signal, a jitter spectrum derived from the signal is filtered, so that the filtered jitter spectrum substantially only comprises one or more deterministic spectral components identified as being expected to result from a deterministic jitter component in the signal resulting from a deterministic and non-random cause. A jitter modulation signal is derived by transforming the filtered identified one or more deterministic spectral components into the time domain, wherein the jitter modulation signal represents a deterministic jitter signal modulated on the signal.

Various alternatives or combinations thereof can be applied for identifying deterministic spectral components in the jitter spectrum: one or more threshold values may be applied, and the spectral components are identified when exceeding one or more of the threshold values. Harmonic frequencies belonging to one or more fundamental frequencies might be evaluated. Spectral peaks can be identified that follow a given pattern and/or a sequence on the frequency axis. A-priori knowledge on the periodicity of an expected jitter modulation signal can be used to identify the deterministic spectral components at expected frequencies taking into account particularly harmonic frequencies belonging to a fundamental frequency of the expected jitter modulation signal. Search algorithms may be applied on the spectral components of the obtained jitter spectrum to identify spectral peaks that follow a given pattern or sequence on the frequency axis. Spectral components with substantially non-random energy content, with energies exceeding a certain value, at specific known frequencies, following a given sequence of pattern, in a certain frequency band, etc. may be selected.

In case that plural jitter modulation signals are present or at least expected to be present, determined deterministic spectral components can be assigned to groups of deterministic spectral components, wherein each group of deterministic spectral components is related to a different deterministic jitter modulation signal. Defining a group of deterministic spectral components might be accomplished by various alternatives or combinations thereof e.g.: by harmonic relationship, wherein the determined deterministic spectral components in that group have harmonic frequencies belonging to a fundamental frequency; by frequency range, wherein the determined deterministic spectral components in that group have frequencies within that frequency range; by individual shaping, wherein each determined deterministic spectral component in the individual group has a given shaping; group shaping, wherein the determined deterministic spectral components in that group have a given shaping determined by at least one of: frequency distribution of phase and magnitude, amplitude waveform in the time domain.

Filtering may be provided e.g. by the following alternatives or combinations thereof: passing only the spectral content at selected frequencies and discarding the others, amplifying only the spectral content at the selected frequencies, attenuating the spectral content at the not selected frequencies. Filtering is preferably done in the frequency domain but equivalent time domain filters can be applied accordingly.

The jitter spectrum preferably represents the spectral components of jitter determined for the signal, preferably in the frequency domain. The jitter spectrum can be obtained by deriving an error signal, preferably a binary error signal, from the signal, and deriving the jitter spectrum from the error signal, preferably by providing a transformation into the frequency domain. Alternatively or in combination thereto, the error signal can be derived by comparing the signal with a reference signal at a plurality of different timing points.

According to one embodiment, a jitter analysis is provided for a signal to be measured having transitions between logical levels. At each of a plurality of successive timing points, a detection of the signal at that timing point is provided. The result of the detection is compared with a reference signal, and an error value is derived therefrom for each timing point. Each error value represents a matching information between a detected transition (or non-transition) and an expected transition (or non-transition) for the respective timing point.

An error signal is then provided representing the derived error values relative to its respective timing points, or in other words, the error signal represents the plurality of the derived error values, each error value being associated with its respective timing point. The error signal thus shows the variation of the error values, with the variation might be provided over the time (absolute or relative time scale) or any other scale derived from the timing points. Thus, the error signal can be e.g. the derived error values over the plurality of successive timing points. Instead of the plurality of successive timing points, other bases of the error values in the error signal can be derived from the plurality of successive timing points, such as an absolute or relative time scale. Accordingly, a pseudo time scale can be provided with the plurality of successive timing points as successive events independent of the actual time difference between successive events. This is in particular useful in case the error values are sampled periodically.

It goes without saying that the error signal (that preferably is formed by a single bit comparison and thus has a binary coding) may also be formed otherwise such as by a multilevel threshold comparison to a reference signal represented by binary or multilevel coding. In such context, the error signal has a multilevel representation (e.g. N-ary amplitude quantization or coding) but still contains all relevant information for jitter analysis. Further, the error signal might be derived by directly comparing the waveforms of the signal with the reference signal (an in particular with an expected signal representing the signal as expect to receive without being subject to jitter or failure influences), e.g. by 'subtracting' the waveform of the reference signal from the waveform of the signal, or vice versa. However, any other type of processing allowing to substantially remove all non-jitter related content (and in particular to remove any data content) from the signal can be applied accordingly in order to derive the jitter spectrum.

A spectral jitter processing is then deployed to the error signal in order to detect spectral components in the error signal and/or to derive the jitter spectrum, which might represent relevant spectral information of jitter contained in the signal. It will be appreciated that substantially any known method for spectral processing can be applied for the spectral jitter analysis of the error signal, such as auto-correlation, cross-correlation, Fourier-Analysis, etc. Preferred examples for spectral analysis are disclosed e.g. in A. Papoulis: Probability, Random Variables and Stochastic Processes, McGraw Hill 1965, or in J. S. Bendat: A. G. Piersol, Random Data, John Whiley&Sons, 1986. It goes without saying that the specific context of different measurements might render one or more of the known spectral analysis method more or less applicable.

Embodiments of the invention thus allow analyzing the signal for spectral components resulting from jitter influences, deriving the jitter spectrum, and/or deriving jitter modulation signals modulated on the signal. Identified spectral components might then be applied for taking further actions e.g. to avoid or reduce jitter at specific frequencies or for quality checks. Preferred examples are evaluating quantitative presence of known spectral jitter components in the signal or a pass/fail test if one or more such known spectral jitter components exceed one or more given thresholds. Accordingly, the knowledge about detected jitter modulation signals can be applied to find and reduce or eliminate causes of the jitter modulation. Quantitative evaluations of jitter modulation signals in the signal, or a pass/fail test (if one or more such jitter modulation signals exceed one or more given thresholds) might result.

The timing points for detecting transitions in the signal are preferably selected in ranges wherein transitions are likely (e.g. under the influence of jitter). Preferably, timing points are selected substantially in the middle of such range wherein transitions are likely under the influence of jitter. Such transition ranges can be determined e.g. using known techniques such as the aforementioned jitter histograms, bit error rate (BER) measurements, or eye diagram measurements, etc.

In a preferred embodiment wherein transitions in the signal are related to a reference signal (e.g. a clock signal) having a reference frequency, the distance between successive timing points is preferably derived from the reference frequency (e.g. as the period, or multiples or fraction thereof, of the reference frequency). The timing points are preferably selected at timings when transitions are expected without influence of jitter, preferably in the middle of a transition area as e.g. determined using an aforementioned eye-diagram.

The transition detection is possible in various ways, preferably by detecting the signal value at a level threshold at a given reference timing point (BER test eq uipment) or by evaluating the sampled signal waveform (Oscilloscope).

The reference signal is preferably one of: an expected signal substantially representing the signal expected to receive (as used e.g. in EP-A-1241483 by the same applicant), an expected signal substantially representing a data content of the signal expected to receive, a signal derived from the signal, a digital signal derived from the signal (as used e.g. in European Patent Application No. 02017333.2 by the same applicant), a constant signal, an arbitrary test signal (as used e.g. in International Patent Application No. WO/EP03/50365 by the same applicant), etc. Preferred alternatives for the arbitrary test signal are: a signal independent of the digital data signal, a signal unrelated to data content of the digital data signal, a signal non-correlated to the digital data signal, a signal with no deterministic relationship with the digital data signal, a signal independent of the digital data signal, an arbitrary test value, a fixed logic value, preferably one of a logic HIGH and a logic LOW signal, one logic level of the digital data signal, a pseudo random binary sequence PRBS, an alternating signal, a signal of alternating logic values, preferably alternating between a logic HIGH and a logic LOW signal.

The signal can by any kind of signal to be tested such as a digital signal having transitions between logical levels, or an analogue signal, etc.

The invention can be partly or entirely embodied or supported by one or more suitable software programs, which can be stored on or otherwise provided by any kind of data carrier, and which might be executed in or by any suitable data processing unit. The invention may also be partly or entirely embodied or supported by dedicated electronic hardware not related to software or firmware execution such as a hardwired ASIC. Accordingly, combinations of software and hardware solutions might also be employed.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference sign(s).

Figs. 1-2 illustrate the effect of sinusoidal jitter modulation onto a random digital data signal and the resulting error signal.

Fig. 3 shows an example of an embodiment according to the present invention.

Figs. 4-7 illustrate the effect of jitter modulation and random jitter content onto a random digital data signal, the resulting error signal the jitter spectra, and the extracted jitter modulation waveform.

Figs. 8 illustrates the influence of the position of the sampling point.

### DETAILED DESCRIPTION OF EMBODIMENTS OF THE INVENTION

For validation and characterization of digital circuit designs, it is of advantage not only to quantify the amount of jitter measured but also to analyze it for its spectral content to localize its origin and/or analyze the time dependent waveform and amplitude and to understand the mechanisms of interference. In order to allow elimination or reduction of deterministic jitter in a design, the generated jitter is analyzed for its deterministic content by decomposing it into its spectral contents and/or extract the deterministic content using a frequency selective filtering of an error signal obtained from comparing the digital data signal. Whereas the energy of random jitter modulation is generally spread into wide frequency band, deterministic jitter usually manifests itself with a concentration of energy into (e.g. a few) discrete modulation frequencies. The ability to determine those frequencies and/or extract the jitter waveform of the deterministic content might provide insight into root causes and allows quantification of the deterministic jitter. It can therefore significantly speed up the debugging process.

In the following, preferred embodiments are described for providing spectral analysis on jitter and/or jitter modulation analysis using a bit error rate tester (BERT) such as the aforementioned Agilent® 81250 ParBERT® . However, it is clear that the invention is not limited to BERTs, but that any other test equipment can be provided for deriving the error signal from comparing detected with expected transitions at defined timing points or sampling and evaluating the entire signal waveform.

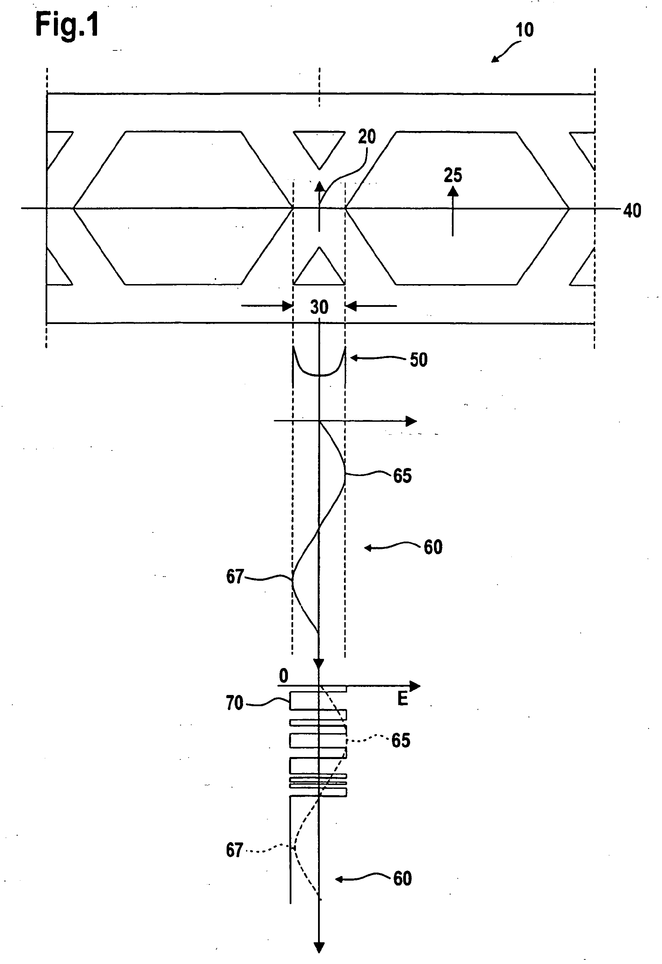

For explaining principles of embodiments of the present invention, Fig. 1 illustrates in an example the effect of a purely sinusoidal jitter modulation onto a random digital data signal. It is noted that the invention can also be applied on other types of signal, such as analog signals, and is not limited to random signals. However, in order to demonstrate effects of inventive embodiments, random digital data signal have been shown to be of advantage.

The upper part of Fig. 1 shows a typical eye diagram 10 with a plurality of transitions superimposed. For the sake of clarity, only the 'borders' of superimposed lines are shown. In this example, a sampling point 20 is selected to be within a transition range 30 determined by all detected transitions occurring at a given threshold level 40. Preferably, the sampling point 20 is selected substantially in the middle of the transition range 30 for a given threshold level 40 of substantially 50%. The sampling point 20 might also be selected using a Jitter Histogram 50, and is preferably selected at the center of gravity of the Jitter Histogram 50.

At the sampling point 20, strobing is provided by comparing each detected signal value with the value expected in the 'center' of the data eye (e.g. in the eye to the right, indicated by a reference timing point 25). Whenever a transition is displaced such that the data eye closes (displacement to the right in the eye diagram 10 of Fig. 1), the strobing will result in an error.

For the sake of better understanding, a sinusoidal jitter modulation 60 onto a random digital data signal shall be assumed. While the random data signal allows an easier explanation, it is clear that the invention can be applied for any kind of signal. Without the jitter modulation 60, all transitions of the digital data signal would occur precisely at the sampling point 20. However, the jitter modulation 60 will periodically displace the transitions of the digital data signal 'around' the sampling point 20, thus leading to the transition range 30. Just from looking at the jitter histogram 50, no conclusion can be made on the frequency of the jitter modulation 60.

Whenever the jitter modulation 60 displaces the transitions to the right in Fig. 1 and comparison is performed e.g. to the value as expected at the reference timing point 25 of the right data eye center, the strobing will result in errors. Due to the displacement of the transitions, the value of the left data bit is actually compared to what is expected at the reference timing point, thus resulting in an error.

Since we assume random data, the BER will be 0.25, because in 50% of the cases during the positive portion 65 of the jitter modulation sine wave 60 adjacent bits are equal in value and no transition will occur between the sampled and the expected bit. Thus, the jitter has no impact on that particular bit. In contrary, when the displacement is opposite (i.e. during the negative portion 67 of the jitter modulation sine wave 60 no error will occur. No error occurs, because the data eye to the right is opened by the displacement (displacement to the left in Fig 1), which allows to sample the expected value despite the offset of the current sampling point 20 to the reference data point 25. Thus, the error signal 70 (with the errors E depicted over the time) is modulated in its error density according to the jitter frequency of the jitter modulation 60.

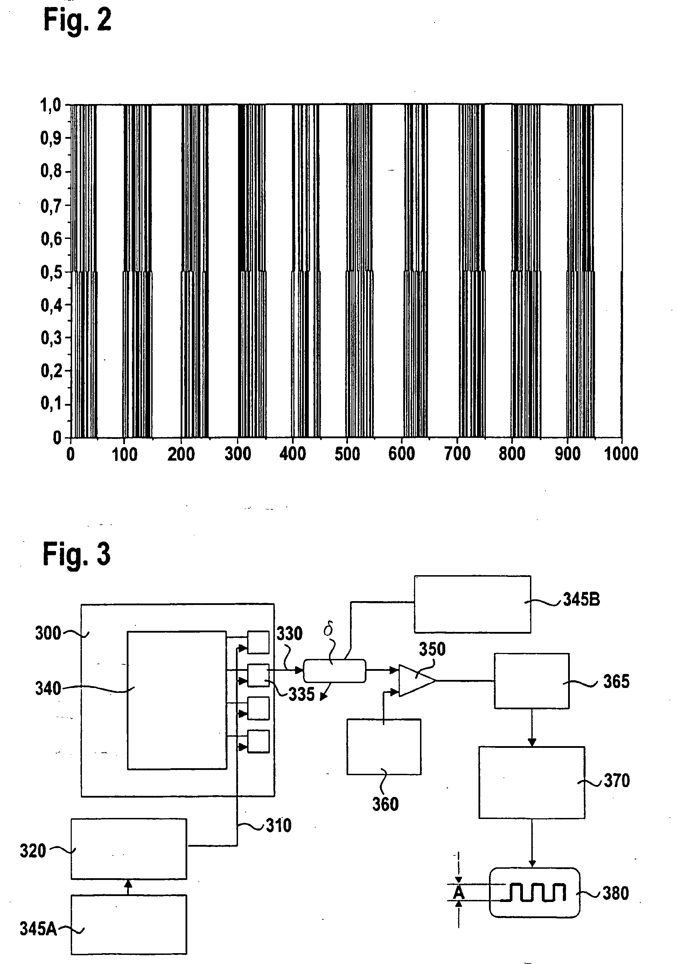

Fig. 2 shows an example of the result of a simulation of what is shown schematically in Fig. 1. Fig. 2 represents the logical values (represented by 0 and 1) of the generated error signal 70 over the time. The error signal 70 shows a periodic modulation of the error density. The periodicity appears as a segment with zero errors followed by a segment with 50% errors.

Fig. 3 depicts an embodiment for executing jitter analysis as illustrated for Figs. 1-2. A device under test (DUT) 300 receives a clock signal 310 from a clock generator 320 and provides an output signal 330 at one or more output ports. In the example of Fig. 3, the clock signal 310 is applied to a plurality of input/output (IO) cells 335, each of those receiving data signals (e.g. at lower data rate in parallel) from a digital core 340 of the DUT 300 and output the data (e.g. serially at high data rate). The digital core 340 represents the plurality of digital and optionally analog processing units in a highly integrated and complex system-on-a-chip device.

In order to allow the analysis of deterministic jitter in either the frequency or modulation time domain the presence of either intrinsic random jitter or intentionally injected auxiliary jitter of known characteristic is advantageous. In case the intrinsic jitter is not sufficient to achieve a quantified analysis, auxiliary jitter, preferably random jitter of high bandwidth or sinusoidal jitter of known frequency, might be injected. In the example of Fig. 3, this can be done either through the reference clock generator 320 using phase modulation and a modulation source 345A, or through a jitter injection unit δ coupled to the output signal 330 and using a modulation source 345B (which can be substantially the same as the noise generator 345A).

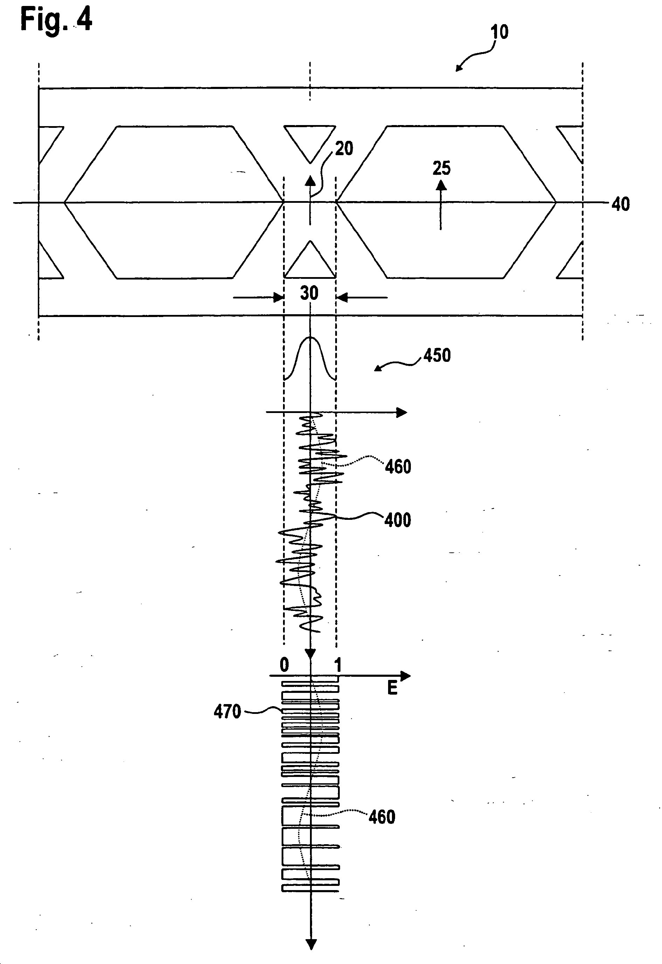

A comparator 350 receives the output signal 330 (with or without additional jitter modulation), compares the received signal against a reference signal 360 at respective sampling points, and provides as output e.g. the error signal E as depicted in the lower part of Fig. 1 and 4. The existence of either the intrinsic random jitter generated in the DUT 300 itself or the auxiliary jitter injected intentionally as described above causes the output signal 330 that is compared against a reference signal 360 in the comparator 350 to vary across the compare threshold of the comparator 350 and thus transferring the deterministic jitter content into a density modulation of the error signal at the output of the comparator. However, it is noted that the auxiliary jitter injection is only optional and provides certain advantages as will be illustrated later.

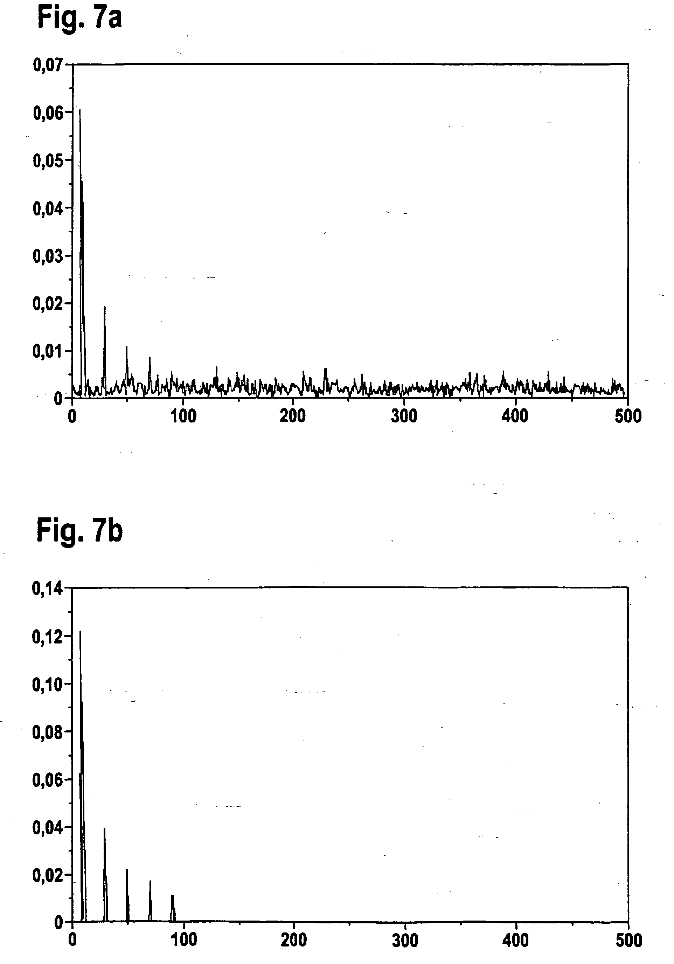

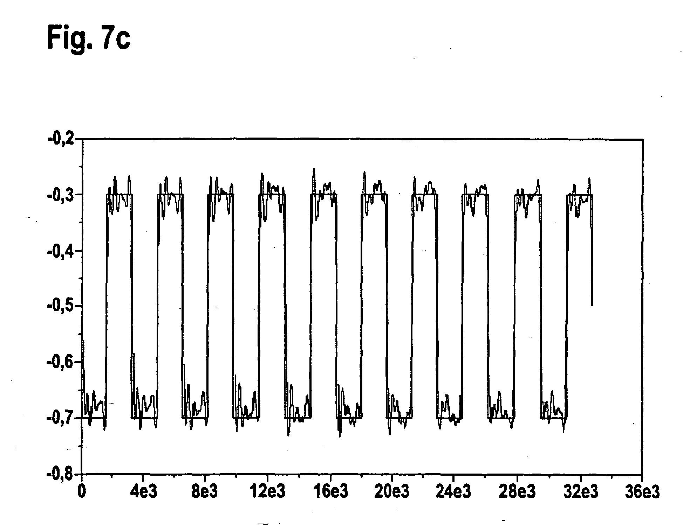

An analysis unit 365 receives the output from the comparator 350 and derives therefrom a jitter spectrum (e.g. as shown in Fig. 7A). A post-processing unit 370 processes the jitter spectrum to identify the deterministic jitter components in the jitter spectrum and accordingly filters the jitter spectrum to substantially eliminate all other components in the jitter spectrum except the identified deterministic jitter components (e.g. as shown in Fig. 7B). The post-processing unit 370 then further allows deriving a jitter modulation signal 380 (representing a deterministic jitter signal modulated on the signal 330) by transforming the filtered identified deterministic spectral components into the time domain. Further analysis on the jitter modulation signal 380 can then be made, e.g. determining amplitude, symmetry, rise/fall time, over/undershoot, etc.

In case of the pure sinusoidal jitter 60 modulated onto the random digital data signal in Fig. 1, the jitter modulation signal 380 of Fig. 3 will represent such sinusoidal jitter signal (subject to more or less distortion as dependent on the processing limitations). It is needless to say that the sinusoidal jitter shape 60 can be replaced by any other (e.g. analog) modulation waveform that can be equivalently extracted with the described method from the data signal 330 in terms of a respective signal 380.

Pure sinusoidal jitter (as shown in the example of Figs. 1-2) rarely occurs in reality. Typically, real systems show intrinsic random jitter caused by thermal and scattering noise potentially mixed with deterministic jitter as a result from design errors. Since it is the result of many different uncorrelated contributors the intrinsic random jitter generally shows up with a Gaussian distribution. An example where sinusoidal jitter 460 and random jitter intrinsically generated or artificially injected is mixed to form the composite jitter signal 400 is shown in Fig. 4.

As long as the peak-to-peak amplitude of the sinusoidal jitter 460 (dotted line) does not substantially exceed the rms value of the random jitter, the distribution of the composite jitter in the Jitter Histogram 450 still shows up with a bell like distribution that makes separation of sinusoidal and random jitter difficult.

When random and sinusoidal jitter are mixed and the sinusoidal jitter 460 does not exceed the random jitter by far, the error signal 470 generated by sampling in the sampling point 20 (here: crossover point of the transitions) again shows up with a periodic modulation of the error density. The difference to the pure sinusoidal jitter (as depicted in Fig. 1) is that now the negative portion of the sinusoid also generates errors but with smaller density than during the positive portion. Therefore the waveform shape of the sinusoidal jitter 460 gets transferred in a similar way into the error signal 470 and can be extracted e.g. by frequency selective filtering.

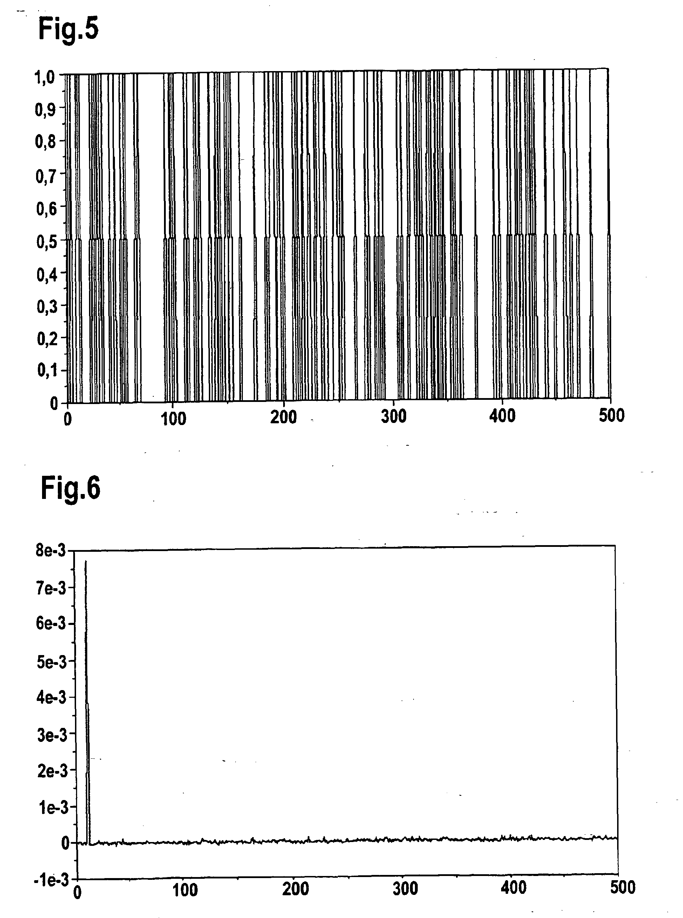

Fig. 5 shows a simulated error signal 470 caused by sinusoidal and random jitter. The periodicity or modulation waveform shape in the error density is hardly visible and the signal appears to have a random character.

Fig. 6 shows the result of the respective simulation with sinusoidal jitter 460 mixed with random jitter to form the signal 400 as of Fig. 4, with the frequency of the sinusoidal modulation 460 appearing as a peak.

The error signal 470 contains all of the information of the original jitter modulation waveform 400 that is the sum of the deterministic waveform 460 and the random jitter. Since a broadband noise signal (here the random jitter) represents a continuous flat power density spectrum, the energy is equally distributed over a wide range of frequencies and thus is typically small in magnitude in a narrow section of the spectrum. In contrary when a periodic signal (here the deterministic jitter) is contained in a broadband noise signal the power density of the periodic signal is strongly concentrated in few (typically equidistantly spaced) discrete lines. Therefore, it is possible to extract the deterministic portion of the jitter modulation waveform 460 by frequency selective filtering that emphasizes the deterministic content and suppresses the random content of the total jitter modulation in the signal 400.

Therefore, when filtering is applied to the jitter spectrum (as e.g. of Fig. 7B), it is possible to extract the deterministic jitter modulation waveform with only minimal distortion compared to the original shape.

Figs. 7A-7C illustrate an example, wherein instead of sinusoidal (as in Fig. 4) a rectangular jitter modulation 460 occurs. Accordingly, the jitter spectrum in Fig.7A shows a plurality of distinctive peaks resulting from such deterministic rectangular jitter modulation 460.

Such deterministic spectral components can be identified in the jitter spectrum by applied adequate peak identification algorithms as well-known in the art as well as by using the human eye or combinations of both. Typically, threshold values may be applied, and the spectral components are identified when exceeding the threshold values. A-priori knowledge on the periodicity of an expected jitter modulation signal can be used to identify the deterministic spectral components at expected frequencies taking into account particularly harmonic frequencies belonging to a fundamental frequency of the expected jitter modulation signal. Search algorithms may be applied on the spectral components of the obtained jitter spectrum to identify spectral peaks that follow a given pattern or sequence on the frequency axis. Spectral components with substantially non-random energy content, with energies exceeding a certain value, at specific known frequencies, following a given sequence of pattern, in a certain frequency band, etc. may be selected. Other peak identifying algorithms are also disclosed e.g. in WO-A-00/77674.

In case that plural jitter modulation signal are present, determined deterministic spectral components can be assigned to groups of deterministic spectral components, wherein each group of deterministic spectral components is related to a different jitter modulation signal. Defining a group of deterministic spectral components can be accomplished by e.g. harmonic relationship, by frequency range, by individual shaping of the spectral component, or by group shaping (e.g. frequency distribution, amplitudes, etc.).

In the example of Fig. 7A, a plurality of deterministic spectral peaks be easily identified (e.g. by applying threshold values and harmonic relationship) in the jitter spectrum. The jitter spectrum can then be filtered accordingly to substantially only show the identified deterministic spectral components as shown in Fig. 7B. Filtering may be provided e.g. by passing on ly the spectral content at selected frequencies and discarding the others, amplifying only the spectral content at the selected frequencies, attenuating the spectral content at the not selected frequencies, using low pass, band pass or multi-passband rake/comb filtering, etc.

The jitter modulation signal 460 can derived from the filtered jitter spectrum of Fig. 7B by transforming the filtered identified one or more deterministic spectral components into the time domain. Fig. 7C shows the thus derived together with the 'original' jitter modulation signal 460. It is clear that due to the omission of higher frequency spectral components and the remaining influence of random jitter components that coincidence with the filtered deterministic components, the derived jitter modulation signal 460 deviates from the 'original' rectangular shape.

An improvement of the result shown in Fig. 7C is possible by processing a higher number of relevant sampling points as used for the simulation. Further improvement can be achieved by performing the filtering with less bandwidth per selected component to avoid the leakage of random components into the passband for the deterministic component. Additional improvement is possible by discarding less of the deterministic components by using a more sophisticated deterministic peak detection.

The fact that the spectral density of the random portion gets distributed over many frequencies while the spectral components of the sinusoidal portion stays concentrated in a single line significantly enhances the detection of spurious deterministic jitter components deeply buried in random jitter. Thus, even small sources of deterministic jitter can be identified.

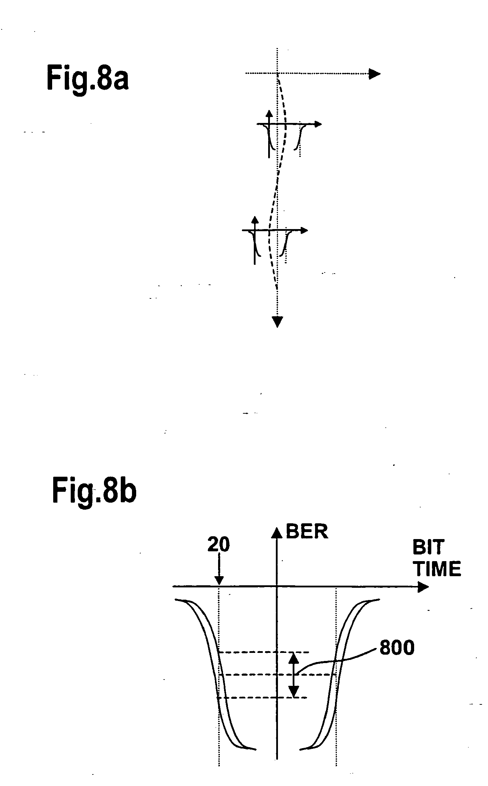

The influence of the position of the sampling point 20 is explained schematically in more detail in Figs. 8A and B. The distribution of a composite jitter modulation signal consisting of random and sinusoidal jitter on the error rate can be perceived as a sinusoidally shifted Gaussian distribution. This means also that a virtual purely random BER curve is moving sinusoidally left and right on the bit time axis (x-axis in Fig. 8B) due to the sinusoidal component. Therefore, the depth of error density modulation 800 depends on the steepness of the BER curve at the strobe point (the sampling point 20) provided the sinusoidal component is small. From this consideration follows that the optimum sensitivity can be obtained with the sampling point 20 offset by 0.5UI (UI = Unit Interval) from the data eye center (as shown in Figs. 1 and 4) or respectively from the center of gravity of the jitter histogram.

The aforedescribed ways to analyze composite jitter containing deterministic (periodic) and random jitter and to extract the underlying deterministic waveform (and e.g. its key parameters such as amplitude and frequency), has been shown particularly useful for design validation and debugging when the sources of the deterministic portions are unknown. However, the extraction of the modulation waveform and, for example, the extraction of the deterministic jitter amplitude might also be of great value for production testing particularly as long as the influence of process variations on the design is not optimized.

In case, however, when it is already known or expected that a problem caused by deterministic jitter of a well-known frequency may exist, a pass/fail test might be provided useful e.g. for production testing. A typical case might be e.g. when process variations or other manufacturing defects result in jitter crosstalk from a known source. Such pass/fail test might be applied in a production test-flow to test for the occurrence of such faults for the deterministic jitter. In case a known deterministic jitter of a given waveform exists, a pass/fail test (e.g. on the deterministic jitter modulation amplitude) might be provided e.g. for production testing.

The random jitter might be calculated from the total jitter and the deterministic jitter extracted as described above. The random jitter might also be subject to a pass/fail test provided for production testing.

The method described above may be applied to any data or clock signal that is not necessarily generated by a device under test 300 as described in Fig. 3 but may be generated in any other way such that jitter is generated that can be analyzed.

## Claims

1. A method for providing a jitter analysis for a signal (330), the method comprising the steps of:
(a) receiving a plurality of error values, each error value being associated with one of a plurality of successive timing points, and each error value being derived from a comparison of the signal (330) at its associated timing point with a reference signal (360),
(b) providing an error signal (70) representing the derived error values relative to their respective timing points,
(c) providing a spectral analysis of the error signal (70) derived from the signal (330) in order to derive a jitter spectrum (Fig.7A) from the error signal (70),
(d) filtering (370) the jitter spectrum (Fig.7A), so that the filtered jitter spectrum (Fig. 7B) substantially only comprises one or more deterministic spectral components identified as being expected to result from a deterministic jitter component in the signal (330) resulting from a deterministic and non-random cause, and
(e) deriving (370) a jitter modulation signal (380; Fig.7C) by transforming the filtered identified one or more deterministic spectral components into the time domain, wherein the jitter modulation signal (380) represents a deterministic jitter signal (460) modulated on the signal (330).

2. The method of claim 1, further comprising the steps of:
(d) identifying (370) one or more deterministic spectral components in the jitter spectrum, wherein each identified deterministic spectral component is expected to result from a deterministic jitter component in the signal (330) resulting from a deterministic and non-random cause.

3. The method of claim 1 or any one of the above claims, wherein the jitter spectrum (Fig.7A) represents the spectral components of jitter determined for the signal (330), preferably in the frequency domain.

4. The method of claim 2, wherein the step of identifying the one or more deterministic spectral components in the jitter spectrum (Fig.7A) comprises at least one of the steps:
• applying one or more threshold values, wherein spectral components are identified when exceeding one or more of the threshold values,
• evaluating harmonic frequencies belonging to one or more fundamental frequencies,
• identifying spectral peaks following at least one of a given pattern and a sequence on the frequency axis,
• using a-priori knowledge on the periodicity of an expected jitter modulation signal (460) to identify the deterministic spectral components at expected frequencies taking into account particularly harmonic frequencies belonging to a fundamental frequency of the expected jitter modulation signal,
• applying a search algorithm on the spectral components of the obtained jitter spectrum (Fig.7A) to identify spectral peaks that follow a given pattern or sequence on the frequency axis,
• selecting of spectral components with substantially non-random energy content,
• selecting of spectral components with energies exceeding a certain value,
• selecting of spectral components at specific known frequencies,
• selecting of spectral components following a given sequence of pattern,
• selecting of spectral components in a certain frequency band.

5. The method of claim 7 or claim 4, wherein the step of identifying the one or more deterministic spectral components in the jitter spectrum (Fig.7A) comprises a step of:
• assigning one or more of the determined deterministic spectral components to one or more groups of deterministic spectral components, wherein each group of deterministic spectral components is related to a different jitter modulation signal.

6. The method of the above claim, wherein the step of assigning comprises at least one of the steps:
• defining a group of deterministic spectral components by harmonic relationship, wherein the determined deterministic spectral components in that group have harmonic frequencies belonging to a fundamental frequency,
• defining a group of deterministic spectral components by frequency range, wherein the determined deterministic spectral components in that group have frequencies within that frequency range,
• defining a group of deterministic spectral components by individual shaping, wherein each determined deterministic spectral component in that group has a given shaping,
• defining a group of deterministic spectral components by group shaping, wherein the determined deterministic spectral components in that group have a given shaping determined by at least one of: frequency distribution, amplitude.

7. The method of claim 1 or any one of the above claims, wherein the step of filtering comprises at least one of the steps:
• passing only the spectral content at selected frequencies and discarding the others,
• amplifying only the spectral content at the selected frequencies,
• attenuating the spectral content at the not selected frequencies.

8. The method of claim 1 or any one of the above claims, wherein the jitter spectrum (Fig.7A) is derived by the steps of:
• deriving a binary error signal (70), from the signal (330),
• deriving the jitter spectrum (Fig.7A) from the error signal (70), by providing a transformation into the frequency domain.

9. The method of the above claim 1, wherein the error signal (70) is derived by:
• comparing the signal (330) with a reference signal (360) at a plurality of different timing points.

10. The method of the above claim 1, wherein the step a comprises a step of:
• deriving each error value being from a comparison of a result of a detection for a transition occurring in the signal (330) at its associated timing point with the reference signal (360).

11. The method of claim 1 or any one of the above claims, further comprising prior to step a the steps of:
- providing, at each one of the plurality of successive timing points, a detection for a transition occurring in the signal (330) at that timing point, and
- for each one of the plurality of successive timing points, comparing a result of the detection with the reference signal (360) and deriving the error value therefrom.

12. The method of claim 1 or any one of the above claims, comprising at least one of the features:
step c comprises a step of applying a Fourier-Analysis to the error signal (70);
each error value represents a matching information between a detected transition or non-transition and an expected transition or non-transition for the respective timing point;
the error signal (70) represents the plurality of the derived error values, each error value being associated with its respective timing point;
the error signal (70) represents the variation of the error values over the time or any other scale derived from the timing points.

13. The method of claim 1 or any one of the above claims, comprising at least one of the features:
the timing points are selected in ranges wherein transitions are likely;
the timing points are selected substantially in the middle of such ranges wherein transitions are likely under the influence of jitter;
transitions in the signal (330) are related to a reference signal (360) having a reference frequency, a distance between successive timing points is derived from the reference frequency.

14. The method of claim 1 or any one of the above claims, further comprising a step of evaluating a quantitative presence of at least one of: at least one deterministic spectral component and at least one jitter modulation signal (380) in the signal (330).

15. The method of claim 14, further comprising a step of providing a pass/fail test by comparing the evaluated quantitative presence with a given threshold value.

16. The method of claim 15, wherein the pass/fail test fails, if the evaluated quantitative presence exceeds the given threshold value.

17. The method of claim 1 or any one of the above claims, wherein the reference signal (360) is one of:
• an expected signal substantially representing the signal expected to receive,
• an expected signal substantially representing a data content of the signal expected to receive,
• a signal derived from the signal,
• a digital signal derived from the signal,
• a constant signal,
• an arbitrary test signal, preferably at least one of:
• a signal independent of the digital data signal,
• a signal unrelated to data content of the digital data signal,
• a signal non-correlated to the digital data signal;
• a signal with no deterministic relationship with the digital data signal,
• a signal independent of the digital data signal,
• an arbitrary test value,
• a fixed logic value, preferably one of a logic HIGH and a logic LOW signal,
• one logic level of the digital data signal,
• a pseudo random binary sequence PRBS,
• an alternating signal,
• a signal of alternating logic values, preferably alternating between a logic HIGH and a logic LOW signal.

18. The method of claim 1 or any one of the above claims, wherein the signal (330) is one of: a digital signal, a digital signal having transitions between logical levels, an analog signal.

19. The method of claim 1 or any one of the above claims, further comprising a step injecting auxiliary jitter, preferably random jitter of high bandwidth or sinusoidal jitter of known frequency, to the signal (330).

20. A software program or product, preferably stored on a data carrier, for executing all the steps of the method of claim 1 or any one of the above claims, when run on a data processing system such as a computer.

21. An apparatus for providing a jitter analysis for a signal (330), comprising:
a signal generation unit being adapted for receiving a plurality of error values, each error value being associated with one of a plurality of successive timing points, and each error value being derived from a comparison of the signal (330) at its associated timing point with a reference signal, the signal generation unit being further adapted for generating the error signal (70) representing the derived error values relative to their respective timing points,
a signal analysis unit (370) being adapted for providing a spectral jitter analysis of the error signal (70) derived from the signal (330) in order to derive a jitter spectrum (Fig.7A) from the error signal (70), and
a filter (370) adapted for filtering the jitter spectrum (Fig.7A), so that the filtered jitter spectrum (Fig.7B) substantially only comprises one or more deterministic spectral components identified as being expected to result from a deterministic jitter component in the signal (330) resulting from a deterministic and non-random cause,
wherein the signal analysis unit (370) is adapted for deriving a jitter modulation signal (380) by transforming the filtered identified one or more deterministic spectral components (Fig.7B) into the time domain, wherein the jitter modulation signal (380) represents a deterministic jitter signal (460) modulated on the signal (330).

22. The apparatus of claim 21, further comprising:
a spectrum analysis unit (365) adapted for deriving the jitter spectrum (Fig.7A) from the signal (330),
an identificator (370) adapted for identifying the one or more deterministic spectral components in the jitter spectrum.

23. The apparatus of claim 21 or any one of the above claims, wherein the spectrum analysis unit (365) is adapted for executing at least one of the features:
• deriving (350) a binary error signal (70), from the signal (330), and deriving the jitter spectrum (Fig.7A) from the error signal (70), by providing a transformation into the frequency domain;
• comparing the signal (330) with a reference signal (360) at a plurality of different timing points.

24. The apparatus of claim 21, further comprising:
a detector (350) adapted for providing, at each one of a plurality of successive timing points, a detection for a transition occurring in the signal (330) at that timing point,
a comparator (350) adapted for comparing, for each one of the plurality of successive timing points, a result of the detector with a reference signal (360) and deriving an error value (E) therefrom, and
a signal generation unit (350) being adapted for generating an error signal (70) representing the derived error values relative to their respective timing points.

## Patentansprüche

1. Verfahren zum Bereitstellen einer Jitter-Analyse (Impulszittern) für ein Signal (330), wobei das Verfahren die folgenden Schritte umfasst:
(a) Empfangen einer Vielzahl von Fehlerwerten, wobei jeder Fehlerwert jeweils einem aus einer Vielzahl aufeinander folgender Zeitpunkte zugeordnet ist und jeder Fehlerwert aus einem Vergleich zwischen dem Signal (330) an seinem zugehörigen Zeitpunkt und einem Referenzsignal (360) abgeleitet wird,
(b) Bereitstellen eines Fehlersignals (70), das die abgeleiteten Fehlerwerte in Bezug auf die ihnen entsprechenden Zeitpunkte (20) darstellt, und
(c) Bereitstellen einer Spektralanalyse des vom Signal (330) abgeleiteten Fehlersignals (70) zum Ableiten eines Jitter-Spektrums (Fig. 7A) vom Fehlersignal (70),
(d) Filtern (370) des Jitter-Spektrums (Fig. 7A), sodass das gefilterte Jitter-Spektrum (Fig. 7B) im Wesentlichen nur eine oder mehrere erkannte deterministische spektrale Komponenten umfasst, die als aus einer deterministischen Jitter-Komponente im Signal (330) zu erwartend erkannt werden, wobei die Jitter-Komponente eine deterministische und nichtzufällige Ursache hat, und
(e) Ableiten (370) eines Jitter-Modulationssignals (380; Fig. 7C) durch Umwandlung der durch Filterung erkannten einen oder mehreren deterministischen spektralen Komponenten in den Zeitbereich, wobei das Jitter-Modulationssignal (380) ein auf das Signal (330) moduliertes deterministisches Jitter-Signal (460) darstellt.

2. Verfahren nach Anspruch 1, das ferner die folgenden Schritte umfasst:
f) Erkennen (370) einer oder mehrerer deterministischer spektraler Komponenten im Jitter-Spektrum, wobei sich jede aus einer deterministischen Jitter-Komponente im Signal (330) zu erwartende erkannte deterministische spektrale Komponente aus einem deterministischen und nicht zufälligen Ansatz ergibt.

3. Verfahren nach Anspruch 1 oder einem der vorangehenden Ansprüche, bei dem das Jitter-Spektrum (Fig. 7A) die für das Signal (330) ermittelten spektralen Komponenten vorzugsweise in der Frequenzdomäne darstellt.

4. Verfahren nach Anspruch 2, bei dem der Schritt des Erkennens der einen oder mehreren deterministischen spektralen Komponenten im Jitter-Spektrum (Fig. 7A) mindestens einen der folgenden Schritte umfasst:
• Anwenden eines oder mehrerer Schwellenwerte, wobei spektrale Komponenten erkannt werden, wenn sie einen oder mehrere der Schwellenwerte überschreiten,
• Auswerten der Oberschwingungsfrequenzen, die zu einer oder mehreren Grundschwingungsfrequenzen gehören,
• Erkennen von spektralen Spitzenwerten aus mindestens einem Spitzenwert eines vorgegebenen Spektralmusters und einer Reihenfolge auf der Frequenzachse,
• Verwenden von bereits vorhandenem Wissen über die Periodizität eines zu erwartenden Jitter-Modulationssignals (460) zum Erkennen der deterministischen spektralen Komponenten an erwarteten Frequenzen unter besonderer Berücksichtigung zu einer Grundschwingungsfrequenz des zu erwartenden Jitter-Modulationssignals gehörender Oberschwingungsfrequenzen,
• Anwenden eines Suchalgorithmus auf die spektralen Komponenten des erhaltenen Jitter-Spektrums (Fig. 7A) zum Erkennen spektraler Spitzenwerte, die einem vorgegebenen Spektralmuster oder einer Reihenfolge auf der Frequenzachse entsprechen,
• Auswählen spektraler Komponenten mit im Wesentlichen nichtzufälligen Energiewerten,
• Auswählen spektraler Komponenten mit Energiewerten, die einen bestimmten Wert überschreiten,
• Auswählen spektraler Komponenten bei bestimmten bekannten Frequenzen,
• Auswählen spektraler Komponenten gemäß einem Spektralmuster mit einer bestimmten Reihenfolge,
• Auswählen spektraler Komponenten in einem bestimmten Frequenzband.

5. Verfahren nach Anspruch 2 oder Anspruch 4, bei dem der Schritt des Erkennens der einen oder mehreren deterministischen spektralen Komponenten im Jitter-Spektrum (Fig. 7A) den folgenden Schritt umfasst:
• Zuordnen einer oder mehrerer der ermittelten deterministischen spektralen Komponenten zu einer oder mehreren Gruppen deterministischer spektraler Komponenten, wobei sich jede Gruppe deterministischer spektraler Komponenten auf ein anderes Jitter-Modulationssignal bezieht.

6. Verfahren nach dem vorangehenden Anspruch, bei dem der Zuweisungsschritt mindestens einen der folgenden Schritte umfasst:
• Definieren einer Gruppe deterministischer spektraler Komponenten gemäß einer harmonischen Beziehung, wobei die ermittelten deterministischen spektralen Komponenten in dieser Gruppe zu einer Grundschwingungsfrequenz gehörende Oberschwingungsfrequenzen aufweisen,
• Definieren einer Gruppe deterministischer spektraler Komponenten gemäß einem Frequenzbereich, wobei die ermittelten deterministischen spektralen Komponenten in dieser Gruppe Frequenzen innerhalb des Frequenzbereichs aufweisen,
• Definieren einer Gruppe deterministischer spektraler Komponenten gemäß einer individuell gewählten Form, wobei jede ermittelte deterministische spektrale Komponenten in dieser Gruppe eine bestimmte Form aufweist,
• Definieren einer Gruppe deterministischer spektraler Komponenten gemäß einer Gruppenform, wobei die ermittelten deterministischen spektralen Komponenten in dieser Gruppe eine gegebene Form aufweisen, die von der Frequenzverteilung und/oder der Amplitude bestimmt wird.

7. Verfahren nach Anspruch 1 oder einem der vorangehenden Ansprüche, bei dem der Filterungsschritt mindestens einen der folgenden Schritte umfasst:
• Durchlassen ausschließlich der spektralen Inhalte bei ausgewählten Frequenzen und Ignorieren der restlichen spektralen Inhalte,
• Verstärken ausschließlich der spektralen Inhalte bei den ausgewählten Frequenzen,
• Schwächen der spektralen Inhalte bei den nichtausgewählten Frequenzen.

8. Verfahren nach Anspruch 1 oder einem der vorangehenden Ansprüche, bei dem das Jitter-Spektrum (Fig. 7A) durch die folgenden Schritte abgeleitet wird;
• Ableiten eines binären Fehlersignals (70) vom Signal (330),
• Ableiten des Jitter-Spektrums (Fig. 7A) vom Fehlersignal (70) durch Bereitstellen einer Umwandlung in die Frequenzdomäne.

9. Verfahren nach Anspruch 1, bei dem das Fehlersignal (70) durch den folgenden Schritt abgeleitet wird:
• Vergleichen des Signals (330) mit einem Referenzsignal (360) an einer Vielzahl von verschiedenen Zeitpunkten.

10. Verfahren nach Anspruch 1, bei dem der Schritt a den folgenden Schritt umfasst:
• Ableiten jedes Fehlerwertes von einem Vergleich zwischen einem Erkennungsergebnis für einen im Signal (330) an seinem zugehörigen Zeitpunkt eintretenden Übergang und dem Referenzsignal (360).

11. Verfahren nach Anspruch 1 oder einem der vorangehenden Ansprüche, das vor dem Schritt a ferner die folgenden Schritte umfasst:
- Bereitstellen einer Erkennung eines im Signal (330) an diesem Zeitpunkt eintretenden Übergangs an jedem aus der Vielzahl aufeinander folgender Zeitpunkte, und
- Vergleichen eines Erkennungsergebnisse mit dem Referenzsignal (360) und Ableiten des Fehlerwertes daraus für jeden aus der Vielzahl aufeinander folgender Zeitpunkte.

12. Verfahren nach Anspruch 1 oder einem der vorangehenden Ansprüche, das mindestens eines der folgenden Merkmale umfasst:
Schritt (c) umfasst einen Schritt der Anwendung einer Fourier-Analyse auf das Fehlersignal (70);
jeder Fehlerwert stellt eine Information der Übereinstimmung zwischen einem erkannten Übergang oder Nichtübergang und einem zu erwartenden Übergang oder Nichtübergang für den betreffenden Zeitpunkt dar;
das Fehlersignal (70) stellt die Vielzahl der abgeleiteten Fehlerwerte dar, wobei jeder Fehlerwert einem eigenen Zeitpunkt zugeordnet ist;
das Fehlersignal (70) stellt die Änderung der Fehlerwerte über die Zeit oder eine andere von den Zeitpunkten abgeleitete Skala dar.

13. Verfahren nach Anspruch 1 oder einem der vorangehenden Ansprüche, das mindestens eines der folgenden Merkmale umfasst:
die Zeitpunkte werden in Bereichen ausgewählt, in denen Übergänge zu erwarten sind;
die Zeitpunkte werden im Wesentlichen in der Mitte solcher Bereiche ausgewählt, in denen durch Jitter bedingte Übergänge zu erwarten sind,
Übergänge im Signal (330) werden zu einem Referenzsignal (360) mit einer Referenzfrequenz in Beziehung gesetzt, und ein Abstand zwischen aufeinander folgenden Zeitpunkten wird von der Referenzfrequenz abgeleitet.

14. Verfahren nach Anspruch 1 oder einem der vorangehenden Ansprüche, das ferner einen Schritt der Auswertung eines quantitativen Vorkommens einer deterministischen Komponente und/oder eines Jitter-Modulationssignals (380) im Signal (330) umfasst.

15. Verfahren nach Anspruch 14, das ferner einen Schritt des Bereitstellens einer Pass/Fail-Prüfung durch Vergleichen des ermittelten quantitativen Vorkommens mit einem vorgegebenen Schwellenwert umfasst.

16. Verfahren nach Anspruch 15, bei dem das Ergebnis der Pass/Fail-Prüfung negativ ist, wenn das ermittelte quantitative Vorkommen den vorgegebenen Schwellenwert übersteigt.

17. Verfahren nach Anspruch 1 oder einem der vorangehenden Ansprüche, bei dem das Referenzsignal (360) eines der folgenden Signale ist:
• ein zu erwartendes Signal, das im Wesentlichen das erwartete zu empfangende Signal darstellt,
• ein zu erwartendes Signal, das im Wesentlichen einen Dateninhalt des erwarteten zu empfangenden Signals darstellt,
• ein vom Signal abgeleitetes Signal,
• ein vom Signal abgeleitetes digitales Signal,
• ein konstantes Signal,
• ein zufälliges Prüfsignal, vorzugsweise eines der folgenden Signale:
• ein vom digitalen Datensignal unabhängiges Signal,
• ein Signal ohne Bezug auf den Dateninhalt des digitalen Datensignals,
• ein Signal ohne Bezug auf das digitale Datensignal,
• ein Signal ohne deterministische Beziehung zu dem digitalen Datensignal,
• ein vom digitalen Datensignal unabhängiges Signal,
• ein zufälliger Prüfwert,
• ein fester Logikwert, vorzugsweise ein Logiksignal HIGH und/oder LOW,
• ein Logikpegel des digitalen Datensignals,
• eine binäre Pseudozufallsfolge (Pseudo Random Binary Sequence, PRBS),
• ein alternierendes Signal,
• ein Signal aus alternierenden Logikwerten, die vorzugsweise zwischen einem Logiksignal HIGH und einem Logiksignal LOW wechseln.

18. Verfahren nach Anspruch 1 oder einem der vorangehenden Ansprüche, bei dem das Signal (330) eines der folgenden Signale ist: ein digitales Signal, ein digitales Signal mit Übergängen zwischen Logikpegeln oder ein analoges Signal.

19. Verfahren nach Anspruch 1 oder einem der vorangehenden Ansprüche, das ferner einen Schritt des Einspeisens eines Zusatzjitters, vorzugsweise eines zufälligen Jitters mit hoher Bandbreite oder eines sinusförmigen Jitters mit bekannter Frequenz, in das Signal (330) umfasst.

20. Softwareprogramm oder -produkt, das vorzugsweise auf einem Datenträger gespeichert ist, zum Ausführen aller Schritte des Verfahrens nach Anspruch 1 oder einem der obigen Ansprüche, wenn das Programm in einem Datenverarbeitungssystem wie beispielsweise einem Computer ausgeführt wird.

21. Vorrichtung zum Bereitstellen einer Jitter-Analyse für ein Signal (330), die Folgendes umfasst:
eine Signalerzeugungseinheit, die in der Lage ist, eine Vielzahl von Fehlerwerten zu empfangen, wobei jeder Fehlerwert einem aus einer Vielzahl von aufeinander folgenden Zeitpunkten zugeordnet ist und jeder Fehlerwert von einem Vergleich des Signals (330) an dem ihm zugeordneten Zeitpunkt mit einem Referenzsignal abgeleitet wird und die Signalerzeugungseinheit ferner in der Lage ist, das Fehlersignal (70) zu erzeugen, das die abgeleiteten Fehlerwerte in Bezug auf ihre jeweiligen Zeitpunkte darstellt,
eine Signalanalyseeinheit (370), die in der Lage ist, eine Jitter-Spektralanalyse des von dem Signal (330) abgeleiteten Fehlersignals (70) bereitzustellen, um von dem Fehlersignal (70) ein Jitter-Spektrum (Fig. 7A) abzuleiten, und
ein Filter (370), das in der Lage ist, das Jitter-Spektrum (Fig. 7A) so zu filtern, dass das gefilterte Jitter-Spektrum (Fig. 7B) im Wesentlichen nur eine oder mehrere deterministische spektrale Komponenten umfasst, die als aus einer deterministischen Jitter-Komponente im Signal (330) zu erwartend erkannt werden, wobei die Jitter-Komponente eine deterministische und nichtzufällige Ursache hat,
wobei die Signalanalyseeinheit (370) in der Lage ist, durch Umwandlung der durch Filterung erkannten einen oder mehreren deterministischen spektralen Komponenten (Fig. 7B) in den Zeitbereich ein Jitter-Modulationssignal (380) abzuleiten, wobei das Jitter-Modulationssignal (380) ein auf das Signal (330) moduliertes deterministisches Jitter-Signal (460) darstellt.

22. Vorrichtung nach Anspruch 21, das ferner Folgendes umfasst:
eine Spektralanalyseeinheit (365), die in der Lage ist, das Jitter-Spektrum (Fig. 7A) vom Signal (330) abzuleiten,
eine Erkennungseinheit (370), die in der Lage ist, die eine oder mehreren deterministischen spektralen Komponenten im Jitter-Spektrum zu erkennen.

23. Vorrichtung nach Anspruch 21 oder einem der vorangehenden Ansprüche, bei der die Spektralanalyseeinheit (365) in der Lage ist, mindestens einen der folgenden Schritte auszuführen:
• Ableiten eines binären Fehlersignals (70) vom Signal (330) und Ableiten des Jitter-Spektrums (Fig. 7A) vom Fehlersignal (70) durch Ausführen einer Umwandlung in die Frequenzdomäne;
• Vergleichen des Signals (330) mit einem Referenzsignal (360) an einer Vielzahl von verschiedenen Zeitpunkten.

24. Vorrichtung nach Anspruch 21, die ferner Folgendes umfasst:
einen Detektor (350), der in der Lage ist, an jedem aus einer Vielzahl aufeinander folgender Zeitpunkte einen zu diesem Zeitpunkt im Signal (330) eintretenden Übergang zu erkennen,
einen Komparator (350), der in der Lage ist, ein Erkennungsergebnis des Detektors für jeden aus der Vielzahl aufeinander folgender Zeitpunkte mit einem Referenzsignal (360) zu vergleichen und von diesem Vergleich einen Fehlerwert (E) abzuleiten, und
eine Signalerzeugungseinheit (350), die in der Lage ist, ein Fehlersignal (70) zu erzeugen, das die abgeleiteten Fehlerwerte in Bezug auf ihre betreffenden Zeitpunkte darstellt.

## Revendications

1. Procédé destiné à délivrer une analyse de gigue d'un signal (330), le procédé comprenant les étapes de :
(a) réception d'une pluralité de valeurs d'erreurs, chaque valeur d'erreur étant associée à l'un d'une pluralité de points temporels successifs, et chaque valeur d'erreur étant dérivée d'une comparaison du signal (330) à son point temporel associé avec un signal de référence (360),
(b) délivrance d'un signal d'erreur (70) représentant les valeurs d'erreurs dérivées par rapport à leurs points temporels respectifs,
(c) délivrance d'une analyse spectrale du signal d'erreur (70) dérivé du signal (330) afin de dériver un spectre de gigue (figure 7A) à partir du signal d'erreur (70),
(d) filtrage (370) du spectre de gigue (figure 7A) de sorte que le spectre de gigue filtré (figure 7B) comprend sensiblement seulement une ou plusieurs composantes spectrales déterministes identifiées comme étant prévues de résulter d'une composante de gigue déterministe dans le signal (330) résultant d'une cause déterministe et non aléatoire, et
(e) dérivation (370) d'un signal de modulation de gigue (380 ; figure 7C) en transformant les une ou plusieurs composantes spectrales déterministes filtrées identifiées dans le domaine temporel, **caractérisée en ce que** le signal de modulation de gigue (380) représente un signal de gigue déterministe (460) modulé sur le signal (330)

2. Procédé conforme à la revendication 1, comprenant en outre l'étape de :
(d) identification (370) d'une ou plusieurs composantes spectrales déterministes dans le spectre de gigue, **caractérisée en ce que** chaque composante spectrale déterministe identifiée est prévue de résulter d'une composante de gigue déterministe dans le signal (330) résultant d'une cause déterministe et non aléatoire.

3. Procédé conforme à la revendication 1 ou conforme à une des revendications précédentes, **caractérisé en ce que** le spectre de gigue (figure 7A) représente les composantes spectrales de gigue déterminées pour le signal (330), de préférence dans le domaine fréquentiel.

4. Procédé conforme à la revendication 2, **caractérisé en ce que** l'étape d'identification d'une ou plusieurs composantes spectrales déterministes dans le spectre de gigue (figure 7A) comprend au moins l'une des étapes de :
- application d'une ou plusieurs valeurs de seuil, **caractérisée en ce que** les composantes spectrales sont identifiées lorsqu'elles dépassent l'une ou plusieurs des valeurs de seuil ;
- évaluation des fréquences harmoniques appartenant à une ou plusieurs fréquences fondamentales,
- identification des crêtes spectrales suivant au moins l'une d'une configuration et d'une séquence données sur l'axe fréquentiel,
- utilisation d'une connaissance a priori sur la périodicité d'un signal de modulation de gigue prévu (460) pour identifier les composantes spectrales déterministes aux fréquences prévues en prenant en compte des fréquences particulièrement harmoniques appartenant à une fréquence fondamentale du signal de modulation de gigue prévu,
- application d'un algorithme de recherche sur les composantes spectrales du spectre de gigue obtenu (figure 7A) pour identifier des crêtes spectrales qui suivent une configuration ou séquence donnée sur l'axe fréquentiel,
- sélection des composantes spectrales avec un contenu énergétique sensiblement non aléatoire,
- sélection des composantes spectrales avec des énergies dépassant une valeur donnée,
- sélection des composantes spectrales à des fréquences connues spécifiques,
- sélection des composantes spectrales suivant une séquence donnée de configuration,
- sélection des composantes spectrales dans une bande de fréquences donnée.

5. Procédé conforme à la revendication 2 ou conforme à la revendication 4, **caractérisé en ce que** l'étape d'identification d'une ou plusieurs composantes spectrales déterministes dans le spectre de gigue (figure 7A) comprend une étape de :
- allocation d'une ou plusieurs des composantes spectrales déterministes déterminées à un ou plusieurs groupes de composantes spectrales déterministes, **caractérisée en ce que** chaque groupe de composantes spectrales déterministes est lié à un signal de modulation de gigue différent.

6. Procédé conforme à la revendication précédente, **caractérisé en ce que** l'étape d'allocation comprend au moins l'une des étapes de :
- définition d'un groupe de composantes spectrales déterministes par relation harmonique, **caractérisée en ce que** les composantes spectrales déterministes déterminées dans ce groupe possèdent des fréquences harmoniques appartenant à une fréquence fondamentale,
- définition d'un groupe de composantes spectrales déterministes par plage de fréquences, **caractérisée en ce que** les composantes spectrales déterministes déterminées dans ce groupe possèdent des fréquences à l'intérieur de cette plage de fréquences,
- définition d'un groupe de composantes spectrales déterministes par mise en forme individuelle, **caractérisée en ce que** chaque composante spectrale déterministe déterminée dans ce groupe possède une mise en forme donnée,
- définition d'un groupe de composantes spectrales déterministes par mise en forme de groupe, **caractérisée en ce que** les composantes spectrales déterministes déterminées dans ce groupe possèdent une mise en forme donnée déterminée par au moins l'une parmi : la distribution de fréquences, l'amplitude.

7. Procédé conforme à la revendication 1 ou conforme à l'une quelconque des revendications précédentes, **caractérisé en ce que** l'étape de filtrage comprend au moins l'une des étapes de :
- transfert uniquement du contenu spectral à des fréquences sélectionnées et rejet des autres,
- amplification uniquement du contenu spectral aux fréquences sélectionnées,
- atténuation du contenu spectral aux fréquences non sélectionnées.

8. Procédé conforme à la revendication 1 ou conforme à l'une quelconque des revendications précédentes, **caractérisé en ce que** le spectre de gigue (figure 7A) est dérivé par les étapes de :
- dérivation d'un signal d'erreur binaire (70), à partir du signal (330),
- dérivation du spectre de gigue (figure 7A) à partir du signal d'erreur (70), en réalisant une transformation dans le domaine fréquentiel.

9. Procédé conforme à la revendication 1 précédente, **caractérisé en ce que** le signal d'erreur (70) est dérivé par la :
- comparaison du signal (330) à un signal de référence (360) à une pluralité de points temporels différents.

10. Procédé conforme à la revendication 1 précédente, **caractérisé en ce que** l'étape (a) comprend une étape de :
- dérivation de chaque valeur d'erreur étant à partir d'une comparaison d'un résultat de détection pour une transition se produisant dans le signal (330) à son point temporel associé avec le signal de référence (360).

11. Procédé conforme à la revendication 1 ou conforme à l'une quelconque des revendications précédentes, comprenant en outre avant l'étape a les étapes de:
- réalisation, à chacun de la pluralité de points temporels successifs, d'une détection de transition se produisant dans le signal (330) à ce point temporel, et
- pour chacun de la pluralité de points temporels successifs, comparaison d'un résultat de la détection avec le signal de référence (360) et dérivation de la valeur d'erreur à partir de celle-ci.

12. Procédé conforme à la revendication 1 ou conforme à l'une quelconque des revendications précédentes, comprenant au moins l'une des fonctions :
l'étape c comprend une étape d'application d'une analyse de Fourier au signal d'erreur (70) ;
chaque valeur d'erreur représente une information de correspondance entre une transition ou une non-transition détectée et une transition ou une non-transition prévue pour le point temporel respectif ;
le signal d'erreur (70) représente la pluralité des valeurs d'erreurs dérivées, chaque valeur d'erreur étant associée à son point temporel respectif ;
le signal d'erreur (70) représente la variation des valeurs d'erreurs dans le temps ou une quelconque autre échelle dérivée des points temporels.

13. Procédé conforme à la revendication 1 ou conforme à l'une quelconque des revendications précédentes, comprenant au moins l'une des caractéristiques :
les points temporels sont sélectionnés dans des plages dans lesquelles des transitions sont probables ;
les points temporels sont sélectionnés sensiblement au milieu de telles plages dans lesquelles des transitions sont probables sous l'influence de la gigue ;
les transitions dans le signal (330) sont liées à un signal de référence (360) présentant une fréquence de référence, une distance entre des points temporels successifs est dérivée de la fréquence de référence.

14. Procédé conforme à la revendication 1 ou conforme à une des revendications précédentes, comprenant en outre une étape d'évaluation d'une présence quantitative d'au moins l'un parmi : au moins une composante spectrale déterministe et au moins un signal de modulation de gigue (380) dans le signal (330).

15. Procédé conforme à la revendication 14, comprenant en outre une étape de réalisation d'un test réussite/échec en comparant la présence quantitative évaluée avec une valeur de seuil donnée.

16. Procédé conforme à la revendication 15, **caractérisé en ce que** le test réussite/échec échoue, si la présence quantitative évaluée dépasse la valeur de seuil donnée.

17. Procédé conforme à la revendication 1 ou conforme à une des revendications précédentes, **caractérisé en ce que** le signal de référence (360) est l'un parmi:
- un signal prévu représentant sensiblement le signal prévu de recevoir,
- un signal prévu représentant sensiblement un contenu de donnée du signal prévu de recevoir,
- un signal dérivé du signal,
- un signal numérique dérivé du signal,
- un signal constant,
- un signal de test arbitraire, de préférence au moins l'un parmi :
- un signal indépendant du signal de donnée numérique,
- un signal non lié au contenu de donnée du signal de donnée numérique,
- un signal non corrélé au signal de donnée numérique,
- un signal sans relation déterministe avec le signal de donnée numérique,
- un signal indépendant du signal de donnée numérique,
- une valeur de test arbitraire,
- une valeur logique fixe, de préférence l'un parmi un signal logique HIGH et un signal logique LOW,
- un niveau logique du signal de donnée numérique,
- une séquence binaire pseudo aléatoire PRBS,
- un signal alternatif,
- un signal de valeurs logiques alternatives, de préférence alternant entre un signal logique HIGH et un signal logique LOW.

18. Procédé conforme à la revendication 1 ou conforme à l'une quelconque des revendications précédentes, **caractérisé en ce que** le signal (330) est l'un parmi : un signal numérique, un signal numérique présentant des transitions entre des niveaux logiques, un signal analogique.

19. Procédé conforme à la revendication 1 ou conforme à une des revendications précédentes, comprenant en outre une étape d'injection de gigue auxiliaire, de préférence une gigue aléatoire de bande passante élevée ou une gigue sinusoïdale de fréquence connue, dans le signal (330).

20. Programme ou produit logiciel, de préférence stocké sur un support de données, destiné à exécuter l'ensemble des étapes du procédé conforme à la revendication 1 ou conforme à une des revendications précédentes, lorsque exécuté sur un système de traitement de données tel qu'un ordinateur.

21. Dispositif destiné à délivrer une analyse de gigue d'un signal (330), comprenant :
une unité de génération de signal étant adaptée pour recevoir une pluralité de valeurs d'erreurs, chaque valeur d'erreur étant associée à l'un d'une pluralité de points temporels successifs, et chaque valeur d'erreur étant dérivée d'une comparaison du signal (330) à son point temporel associé avec un signal de référence, l'unité de génération de signal étant en outre adaptée pour générer le signal d'erreur (70) représentant les valeurs d'erreurs dérivées par rapport à leurs points temporels respectifs,
une unité d'analyse de signal (370) étant adaptée pour délivrer une analyse de gigue spectrale du signal d'erreur (70) dérivé du signal (330) afin de dériver un spectre de gigue (figure 7A) à partir du signal d'erreur (70), et
un filtre (370) adapté pour filtrer le spectre de gigue (figure 7A), de sorte que le spectre de gigue filtré (figure 7B) comprend sensiblement seulement une ou plusieurs composantes spectrales déterministes identifiées comme étant prévues de résulter d'une composante de gigue déterministe dans le signal (330) résultant d'une cause déterministe et non aléatoire,
**caractérisé en ce que** l'unité d'analyse de signal (370) est adaptée pour dériver un signal de modulation de gigue (380) en transformant les une ou plusieurs composantes spectrales déterministes filtrées identifiées (figure 7B) dans le domaine temporel, **caractérisé en ce que** le signal de modulation de gigue (380) représente un signal de gigue déterministe (460) modulé sur le signal (330)

22. Dispositif conforme à la revendication 21, comprenant en outre :
une unité d'analyse de spectre (365) adaptée pour dériver le spectre de gigue (figure 7A) à partir du signal (330),
un identificateur (370) adapté pour identifier les une ou plusieurs composantes spectrales déterministes dans le spectre de gigue.

23. Dispositif conforme à la revendication 21 ou conforme à une des revendications précédentes, **caractérisé en ce que** l'unité d'analyse de spectre (365) est adaptée pour exécuter au moins l'une des fonctions :
- dérivation (350) d'un signal d'erreur binaire (70), à partir du signal (330), et dérivation du spectre de gigue (figure 7A) à partir du signal d'erreur (70), en réalisant une transformation dans le domaine fréquentiel ;
- comparaison du signal (330) avec un signal de référence (360) à une pluralité de points temporels différents.

24. Dispositif conforme à la revendication 21, comprenant en outre :
un détecteur (350) adapté pour délivrer, à chacun d'une pluralité de points temporels successifs, une détection de transition se produisant dans le signal (330) à ce point temporel,
un comparateur (350) adapté pour comparer, pour chacun de la pluralité de points temporels successifs, un résultat du détecteur à un signal de référence (360) et pour dériver une valeur d'erreur (E) à partir de celui-ci, et
une unité de génération de signal (350) étant adaptée pour générer un signal d'erreur (70) représentant les valeurs d'erreurs dérivées par rapport à leurs points temporels respectifs.
